(19) Europäisches Patentamt
European Patent Office
Office européen des brevets

(11) EP 2 176 708 B1

(12) EUROPEAN PATENT SPECIFICATION

(45) Date of publication and mention of the grant of the patent:
07.10.2015 Bulletin 2015/41

(51) Int Cl.:
G03C 5/00 (2006.01)        H01L 21/00 (2006.01)
G03F 1/26 (2012.01)        G03F 1/32 (2012.01)
G03F 1/86 (2012.01)

(21) Application number: 08795203.2

(22) Date of filing: 11.08.2008

(86) International application number:
PCT/US2008/009595

(87) International publication number:
WO 2009/020662 (12.02.2009 Gazette 2009/07)

(54) **METHOD FOR MODIFYING OPTICAL MATERIAL PROPERTIES**

VERFAHREN ZUR ÄNDERUNG DER OPTISCHEN EIGENSCHAFTEN EINES MATERIALS

PROCÉDÉ PERMETTANT DE MODIFIER DES PROPRIÉTÉS MATÉRIELLES OPTIQUES

(84) Designated Contracting States:
AT BE BG CH CY CZ DE DK EE ES FI FR GB GR HR HU IE IS IT LI LT LU LV MC MT NL NO PL PT RO SE SI SK TR

(30) Priority: 09.08.2007 US 954989 P
28.03.2008 US 40291

(43) Date of publication of application:
21.04.2010 Bulletin 2010/16

(73) Proprietor: Rave LLC
Delray Beach, FL 33445 (US)

(72) Inventors:
• LECLAIRE, Jeffrey, E.
Boca Raton, FL 33433 (US)
• WHITE, Roy
Wellington, FL 33414 (US)
• BRINKLEY, David, W.
Baltimore, MD 21209 (US)
• ROESSLER, Kenneth, G.
Boca Raton, FL 33431 (US)

(74) Representative: TBK
Bavariaring 4-6
80336 München (DE)

(56) References cited:
EP-A1- 1 353 224        EP-A1- 1 777 587
WO-A2-02/27404          US-A- 5 728 494
US-A1- 2004 151 991     US-A1- 2005 208 393
US-A1- 2006 007 433     US-A1- 2006 007 433
US-A1- 2006 147 814     US-A1- 2006 169 913
US-A1- 2006 254 611     US-A1- 2007 128 552
US-B1- 6 407 385        US-B2- 6 870 970

**Description**

CROSS-REFERENCE TO RELATED APPLICATIONS

This application claims priority to U.S. Provisional Patent Application Serial No. 61/040,291, filed March 28, 2008, entitled "Apparatus and Method for Modifying Optical Material Properties," and U.S. Provisional Patent Application Serial No. 60/954,989, filed August 9, 2007, entitled "Apparatus and Method for Indirect Surface Cleaning".

FIELD OF THE INVENTION

The present invention relates generally to the alteration of material with a relative high degree of volumetric and positional accuracy. More specifically, the present invention relates to the removal and addition of material from substrates and items used in the semiconductor industry such as in the modification of semiconductor wafers and photomasks, which are used in photolithography process, the creation of semiconductors and micro and nano structures. The invention can make substrate alterations with dimensions in the nanometer and larger range and relative to surfaces and surface features with nanometer positional accuracy (X, Y and Z).

BACKGROUND OF THE INVENTION

The current state of the art semiconductor manufacturing processes rely on the use of photomasks (reticles) for component production. A photomask typically consists of a highly transmitting substrate coated and patterned with a thin layer(s) of absorbing material. These photomasks are exposed to DUV radiation during normal process use in order to print the mask pattern onto the wafer. Typically the light transmitted through the photomask pattern is transferred to a resist coated semiconductor surface (print process). It is critical that the photomask surface be free of contamination for the print process to work, because contamination on the photomask can absorb or scatter the DUV light and change the illumination pattern generated. Defects (Contamination or other) on the photomask can be imaged along with real structure and cause a failure in the feature generation and therefore the final device.

Because of the criticality of the clean requirement, relatively aggressive cleaning processes are typically required to guarantee a contamination free surface. This cleaning requirement has the affect of decreasing the useable lifetime of a photomask because the nominal processes used deteriorate the absorbing film on the mask. Duplicate sets of photomasks must be made in order to continue manufacturing once the useable life of a photomask is exceeded. The deterioration is particularly a problem for partial absorbing film coated photomasks. For these photomask, the loss of material resulting from the standard cleaning processes results in a loss of phase delay and an increase in transmission through the film. This loss of phase and increase in transmission limits the number of clean process that can be applied before the photomask is no longer usable. The useable life for a photomask with partial absorbing films in particular can be limited by the wet clean process because their performance is critically dependent on the phase and transmission.

It is difficult to significantly reduce the aggressiveness of the wet cleaning process, because it is integral to photomask manufacturing and because of the multiple types of surface contamination possible (resist coatings, residual organics, photo-induced defects, particles, etc.). In addition, the number of cleaning cycles and the aggressiveness of the clean process is exacerbated by several factors. One of the reasons for using a highly aggressive clean process is the removal/exchange of a pellicle frame from the photomask. This process can leave an adhesive residue that is difficult to remove without aggressive cleaning. The number of clean cycles a reticle experiences is dependent on the cleaning required to produce the photomask and how frequently the mask must be sent back for clean after pellicalization and use. One of the contributors to the requirement for cleaning, after completed assembly (including pellicalization) and use, is the growth of photo-induced defects on the reticle during use and storage. These growth defects are commonly referred to as haze and can force a reticle to go through a clean process to be removed. This is particularly true for the most advanced photomasks that have the smallest printable feature sizes because they are affected by very small growth defects.

Efforts have been made to reduce the affects of haze growth defects to reduce the loss of partial absorber caused by the aggressive wet clean chemistries that re-pellicalization requires. These processes include alternate wet clean chemistries, surface preparation and environmental control. In general, these processes have the potential to reduce haze growth defects, but not eliminate the requirement for a wet cleaning. Although these methods can reduce or potentially eliminate the requirement for aggressive wet clean after pellicalization, the effects of wet clean prior to pellicalization can still be an issue.

At least in consideration of the above discussion, it would be advantageous to develop processes that could increase the phase delay and/or decrease the transmission of a partially absorbing material on a photomask surface to recover the changes produced by wet clean processing.

It would be additionally advantageous to develop a novel method and/or apparatus for modifying the phase and/or transmission of a partially absorbing film on a photomask surface that enhances usability, performance, lifetime or other aspect of use.

It would be additionally advantageous to develop a novel laser based method and/or apparatus for modifying the phase and/or transmission of a partially absorbing film on a photomask surface that enhances usability, performance, lifetime or other aspect of use with a reduced potential for surface damage.

It would be additionally advantageous to develop a novel method and/or apparatus for modifying the phase and/or transmission of a partially absorbing film on a photomask surface without pellicle removal.

It would be additionally advantageous to integrate methods and/or apparatuses for modifying the phase and/or transmission of a partially absorbing film on a photomask surface into the photomask fabrication, wafer fabrication and/or repair processes.

It would be additionally advantageous to develop a method and/or apparatus to control critical dimensions on a photomask by locally or globally modifying the phase and/or transmission of a partially absorbing film on a photomask surface.

It would be additionally advantageous to develop a novel laser based method and/or apparatus for modifying the phase and/or transmission of a partially absorbing film on a photomask surface that also produces a thermal based removal of surface contamination and enhances usability, performance, lifetime or other aspect of use with a reduced potential for surface damage.

Prior art which is related to this field of technology can be found e.g. in document WO 02/27404 A2 disclosing mitigation of multilayer defects on a reticle, document US 2006/0007433 A1 disclosing a defect repair device and defect repair method, document US 5,728,494 disclosing an exposure mask and method and apparatus for manufacturing the same, document US 2006/0254611 A1 disclosing an acid-free cleaning process for substrates, in particular masks and mask blanks, document EP 1 353 224 A1 disclosing cleaning of a pellicle-mask assembly, document US 2007/0128552 A1 disclosing a manufacturing method of a pattern formed body and pattern formed body manufacturing apparatus, document US 6,407,385 B1 disclosing methods and apparatus for removing particulate foreign matter from the surface of a sample, and document EP 1 777 587 A1 disclosing a method of cleaning a surface of a photomask.

SUMMARY OF THE INVENTION

Embodiments of the present invention provide a method for improving the optical characteristics of a photomask according to claim 1.

There have thus been outlined, rather broadly, certain features of the invention in order that the detailed description thereof that follows may be better understood, and in order that the present contribution to the art may be better appreciated. There are, of course, additional features of the invention that are described below and form the subject matter of the claims appended hereto.

In this respect, before explaining at least one embodiment of the invention in detail, it is to be understood that the invention is not limited in its application to the details of construction and to the arrangements of the components set forth in the following description or illustrated in the drawings. The invention is capable of other embodiments, and of being practiced and carried out in various ways. It is also to be understood that the phraseology and terminology employed herein, as well as the abstract, are for the purpose of description, and should not be regarded as limiting.

As such, those skilled in the art will appreciate that the conception upon which this disclosure is based may readily be utilized as a basis for the designing of other structures, methods, and systems for carrying out the several purposes of the present invention.

BRIEF DESCRIPTION OF THE DRAWINGS

Figure 1a illustrates a schematic diagram of externally generated thermal excitation of a partially absorber material, in accordance with an embodiment of the present invention.

Figure 1b illustrates a diagram of a patterned partial absorber material on top of a substrate, in accordance with an embodiment of the present invention.

Figure 2 illustrates a plot of a MoSi absorption spectrum from the deep ultraviolet to the far infrared region of the electromagnetic spectrum, in accordance with an embodiment of the present invention.

Figure 3 illustrates a plot of a quartz absorption spectrum from the deep ultraviolet to the far infrared region of the electromagnetic spectrum, in accordance with an embodiment of the present invention.

Figure 4 illustrates a diagram of a photomask surface with thin film partial absorber including pellicle attached to surface, in accordance with an embodiment of the present invention.

Figure 5a illustrates a schematic diagram of a photomask with a pellicle showing a laser beam focused through the pellicle and onto the surface, in accordance with an embodiment of the present invention.

Figure 5b illustrates a schematic diagram of the beam spot size on the pellicle versus on the mask produced by focusing, in accordance with an embodiment of the present invention.

Figure 5c illustrates a schematic diagram of a photomask with a pellicle showing laser beam focused through the pellicle and onto the surface and a side view of the beam spot on the pellicle, in accordance with an embodiment of the present invention.

Figure 6a illustrates a cross sectional view of a gaussian beam energy distribution and the corresponding temperature profile produced, in accordance with an embodiment of the present invention.

Figure 6b illustrates a cross sectional view of a top-hat beam energy distribution and the corresponding temperature profile produced, in accordance with an embodiment of the present invention. According to certain embodiments of the present invention, gaussian, flat top, and/or top hat energy distributions may be used.

Figure 7 illustrates a diagram of a photomask with a cold plate contacting bottom of the mask, in accordance with an embodiment of the present invention. According to certain embodiments of the present invention, the contact point could be, for example, either water (or other liquid or gas) flow through the cold plate or electrical contact for thermoelectric cooling.

Figure 8 illustrates a diagram showing forced convection cooling of areas on the photomask, in accordance with an embodiment of the present invention. According to certain embodiments of the present invention, airflow is directed at the pellicle frame.

Figure 9a illustrates a diagram showing a single pass of the laser beam across surface to minimize local thermal build up, in accordance with an embodiment of the present invention. A single row or column with large lateral spacing between spots is illustrated.

Figure 9b illustrates a diagram showing two passes of the laser beam across surface to minimize local thermal build up, in accordance with an embodiment of the present invention. A single row with two sets of beam spots overlapped with large spacing between sets of pulses is illustrated.

Figure 9c illustrates a diagram showing multiple laser passes over an area of the substrate to achieve material change processing of the section of the substrate, in accordance with an embodiment of the present invention.

Figure 9d illustrates a diagram illustrating a second dimension of material change processing, in accordance with an embodiment of the present invention.

Figure 9e illustrates a diagram representing the use of non-contiguous pulses on the surface, in accordance with an embodiment of the present invention.

Figure 10 illustrates a schematic diagram of a partial absorber material on a substrate with thermocouple or infrared temperature monitoring devices, in accordance with an embodiment of the present invention.

Figure 11 illustrates a schematic diagram of a partial absorber material on a substrate with imaging, microscopy, spectroscopy, or combination system for material property analysis, in accordance with an embodiment of the present invention.

Figure 12 illustrates a schematic diagram of a partial absorber material on a substrate with measurement system where the measurement system and laser beam delivery are common path, in accordance with an embodiment of the present invention.

Figure 13 illustrates a system diagram showing robotic load and X/Y/Z stage motion of a substrate relative to laser beam, in accordance with an embodiment of the present invention.

## DETAILED DESCRIPTION

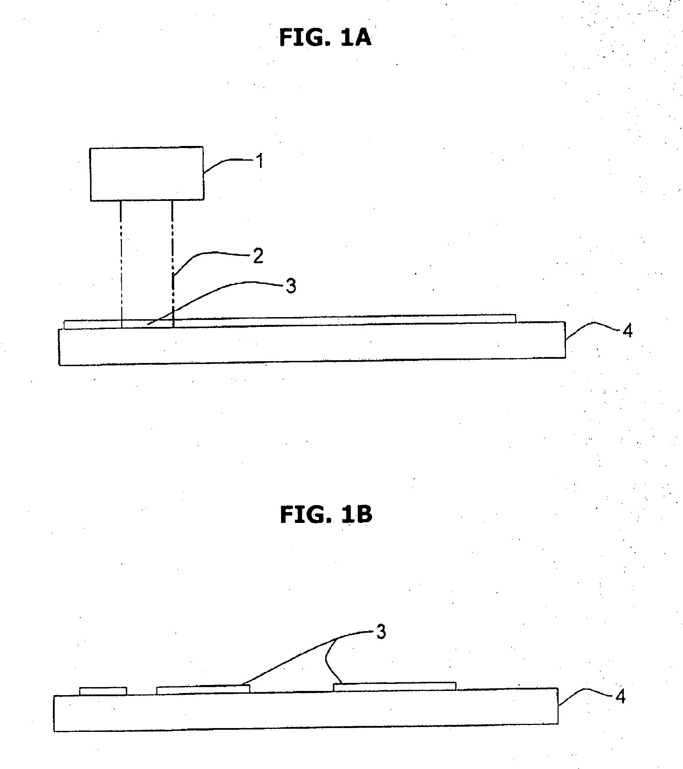

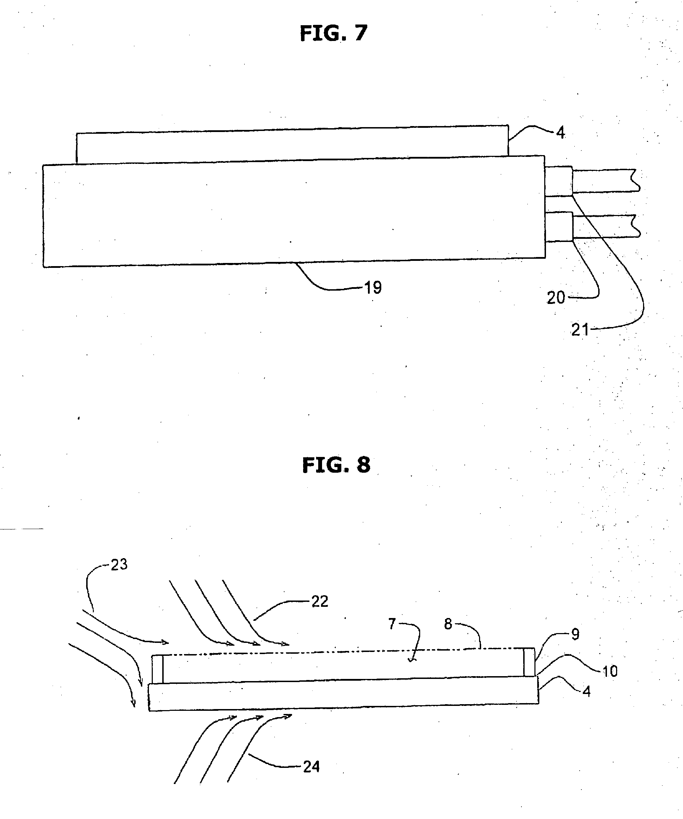

The invention will now be described with reference to the drawing figures, in which like reference numerals refer to like parts throughout. According to certain embodiments of the present invention, a method for modifying a partial absorber material is provided. As illustrated in Figure 1a, a partial absorbing film (3) displaced on a partially or completely transmitting substrate (4) is directly excited. An external energy source (1) may be used to provide the excitation and may be an electromagnetic energy source and more particularly a laser with beam (2) directed toward the target material. An embodiment of the invention also illustrated by Figure 1a, utilizes an external energy source (1) to provide thermal excitation of the substrate material (4) or both the partial absorber (3) and substrate (4) and may include thermal transfer from the substrate to a partial absorber on the substrate (e.g., by convection or conduction). This may be a requirement if the partial absorber material is patterned (Figure 1b) since the directed energy source may interact directly with the substrate. Another alternative embodiment of the method would utilize an energy source attached to the substrate to provide thermal energy enough to produce a material change for a partial absorbing material of the substrate or disposed on the substrate. An illustration including contact thermal exchange device (19) with the substrate is illustrated in Figure 7.

Alternative external energy sources other than laser may be used (e.g., lamps and other devices that can radiate energy all along the electromagnetic spectrum may be used, including generators of x-rays, microwaves, infrared radiation, near-ultraviolet radiation, etc.). The partial absorber material and substrate may be of many different materials. It is also possible that the substrate could have partial absorber properties and may be targeted for material modification without a material disposed on top. The resulting temperature increase in the partial absorber produces a thermally based change in material and/or property, including, but not limited to, dehydration, oxidation, surface roughness, and/or annealing. ,

According to certain embodiments of the present invention, the method has a reduced risk of substrate damage because the temperature typically used to modify the partial absorber is below the thermal damage level of the substrate material(s). The risk of substrate damage is also typically reduced over other techniques because it can, in some instances, utilize relatively long pulse-widths which often reduce the potential for multi-photon absorption processes.

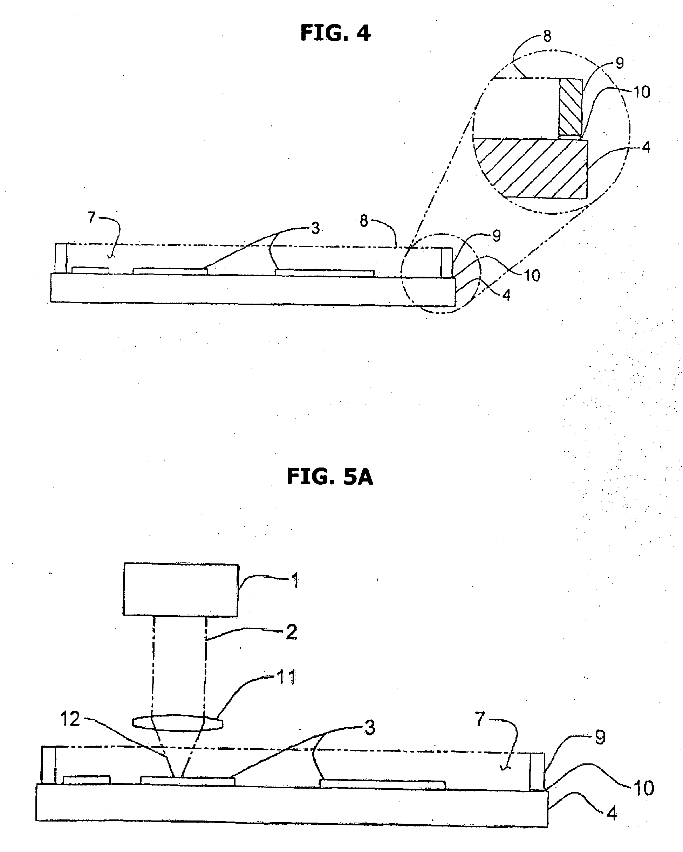

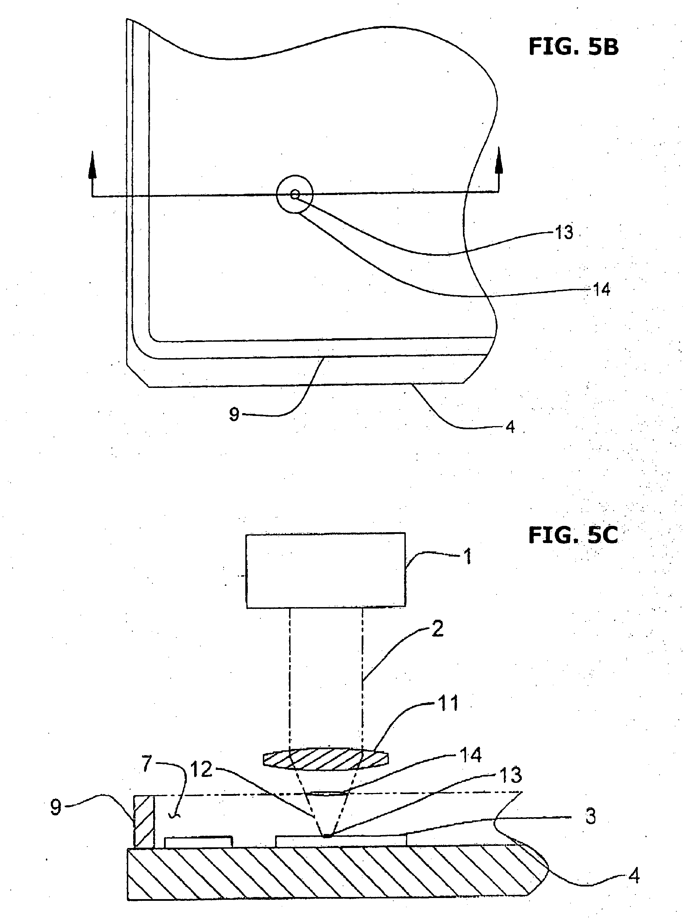

The method may be particularly advantageous for applications where the environment above the partial absorber is substantially or fully enclosed (Figure 4). In these cases, the method may also include directing the beam through a material disposed relative to the surface (8) that is part of the substrates environmental enclosure. For example, the inventive method could be used to modify a partial absorber film on the surface of a pellicalized photomask (Figure 5a), where the pellicle consists of, at least the following, pellicle film (8), pellicle frame (9), and pellicle frame adhesive (10).

According to certain embodiments of the present invention, the method includes selecting a laser wavelength that substantially coincides with a strong absorption of a partial absorber and setting the laser energy and pulse width to produce the desired partial absorber modification. Increased absorption in the substrate, in some instances, allows lower laser energies to be used for the process and, therefore, can decrease the potential for damage to adjacent materials that may interact with the laser as it is directed to or reflected from the surface.

The invention is defined in that a wavelength is selected that is also highly absorbed by the substrate to reduce thermal differences between the partial absorber and substrate. The use of multiple laser wavelengths and/or laser energies may be used if multiple partial absorbers or a substrate that consists of more than one material are used. Multiple wavelengths may be produced, for example, by utilizing multiple laser sources or a single tunable laser source or both. Multiple energies can be used by control of the laser source(s) output energy using controls and/or devices internal or external to the laser(s).

Application of methods according to certain embodiments of the present invention to a substrate consisting of multiple materials may require consideration of the material parameters as well as the beam parameters, including excitation wavelength selection. According to certain embodiments of the present invention, a laser wavelength that has a significant absorption in the partial absorber material is selected. In some embodiments the selected wavelength will have a small absorption in or be highly reflected by other materials on or in the substrate such that the thermal increase will be primarily in the partial absorber material. This may be particularly important if material adjacent to the partial absorber will be affected by the process temperature. For example, in the case of a pellicalized photomask, the pellicle film (8) and pellicle frame adhesive (10) are in close proximity to the partial absorber film. Reducing the overall thermal build up in the system may be important if, for example, if the pellicle frame adhesive outgases or degrades. Minimizing the total thermal buildup may also be important if significant heat is transferred to the environment (7) between the mask surface and the pellicle film since this thermal build up could affect the film, adhesive or pellicle frame (9) materials. It may in some cases be additionally preferred that the process temperature be below the damage or modification levels of the substrate material.

In other embodiments, the basis of the material modification process may make it particularly desirable for all areas of a substrate to reach a temperature substantially near that typically needed for modification without exceeding the thermal damage threshold of the substrate or other adjacent materials. It is possible that the laser energy typically required to bring one of the materials to process temperature will produce thermal damage in the other material, particularly if there is a significant discrepancy between the material absorptions. The local fluence of the beam may be controlled based on the materials being exposed.

According to certain embodiments of the present invention, longer laser pulse widths, up to and including continuous wavelength (CW) lasers, are used to improve the thermal equilibrium between materials with significantly different absorption constants. However, the use of such longer laser pulse widths produce the highest thermal increase in the overall system and may not be useable if a material adjacent to the substrate surface has a thermal damage threshold or other adverse thermally induced affect below the process temperature.

According to certain embodiments of the present invention, a laser wavelength that has a significant absorption for several or all of the materials of the substrate is selected. The same laser energy may then, for example, be used to produce the desired process temperature below any of the substrate materials damage thresholds. By considering the thermal properties (including diffusivity) it is also possible to take advantage of the thermal transfer between the different materials. This, in some cases, allows the use of a reduced process fluence to achieve partial absorber modification across the entire substrate, particularly if the thermal energy flow from a higher absorbing material is preferential to the lower absorbing material.

## Examples

The following is an example of a method according to one embodiment of the present invention applied to modification of a partial absorber film on a photomask substrate that is used in wafer fabrication processes. This example may be used throughout the additional embodiments of the inventive method discussed.

Control of the beam parameters may be particularly desirable in the embodiments of the invention related to photomask partial absorber material modification for phase and/or transmission. Wavelength selection, for example, is highly desirable because of the physical structure of the typical photomask. In most cases, a photomask consists of a quartz substrate with a thin absorbing or partially absorbing film on the critical surface (Figures 1a and 1b). In the case of a metal film, there will typically be a significant absorption coefficient for the majority of producible laser wavelengths. However, in the case of partially absorbing films there may be wavelength regions where these films do not significantly absorb unlike for pure metal films. For the quartz substrate, however, there will generally be a limited wavelength range where the substrate has significant absorption and laser sources are commonly available. Therefore, certain embodiments may utilize a wavelength that is highly absorbed by the partial absorber film while the substrate is weakly absorbing or transparent to the selected wavelength. This process may minimize the overall temperature increase of the system and would reduce the risk of direct absorption damage of the substrate.

A specific example of a representative method according to the present invention is the changing of one or more properties of a partial absorber film on a photomask substrate with laser excitation. For example, a photomask with a Molybdenum Silicon Oxynitride (MowSix-OyNz) film which is commonly referred to as MoSi. The material property change may include the transmitted phase delay and/or transmission of the partial absorber material. Additional changes in surface morphology and/or material reflectivity may also be included since surface roughness will affect reflectivity and reflectivity is interrelated with transmission. The lowest thermal damage point for a photomask will typically be the melting/reflow point for the base quartz substrate (i.e., around 1600 °C). Depending on the exact material characteristics of the MoSi film material changes (eg. Annealing) may occur at temperatures well below the reflow point of the quartz substrate. Therefore, there is a potential process where the temperature for material change can occur below the damage level of the substrate materials.

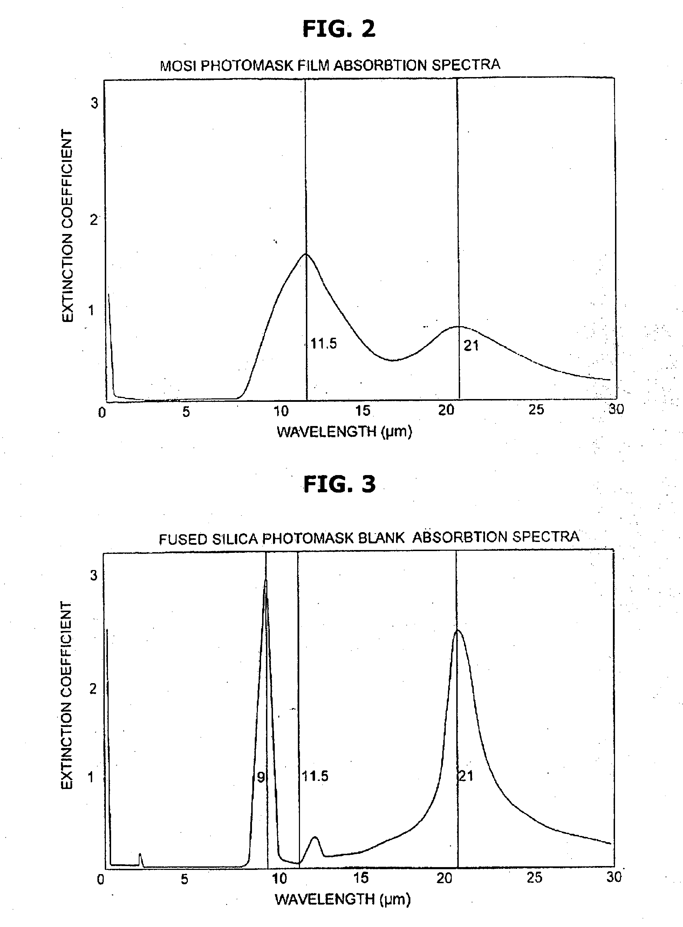

As discussed above, the relative absorption of the substrate materials is generally considered because of potential differences in the material absorption characteristics. It may be desirable to select a wavelength that is highly absorbed by the MoSi film. Figure 2 is schematic diagram of an absorption curve for a MoSi partial absorbing photomask film. In this example, the main absorption occurs either below 0.3 $\mu$m wavelength or above 9 $\mu$m wavelength. The shorter wavelengths are not in a particularly desirable wavelength range, because they are usually significantly absorbed by air and because they have higher photon energy and are more likely to produce multiphoton processes. Selecting a wavelength above 9 $\mu$m, for example near the 11.5 $\mu$m absorption peak, is particularly desirable according to certain embodiments of the present invention. This typically produces a high absorption in the MoSi film without high environmental absorption. This could minimize the total thermal input to the system during use of the current invention by lowering the energy required to produce the material change.

Also as discussed above, consideration of the absorption of the quartz substrate may also be considered. Quartz substrates used for photomasks are typically specifically designed to have high transmission in the deep ultraviolet (DUV) wavelength range (Figure 3). This is typically accomplished by using synthetically fused silica substrates that have an extremely low level of impurities. According to certain embodiment of the current invention it may be an advantage to have a significant absorption in the MoSi and a lower absorption in the quartz substrate. As shown in Figure 3, the absorption for the example quartz substrate does not have a significant absorption at the MoSi film absorption peak. Therefore, processing at a wavelength of 11.5 um, it is possible that thermal build up in the MoSi would occur preferential to the quartz. This could minimize the total thermal input to the system during use of the current invention by minimizing the thermal build up in areas of the substrate without partial absorber.

In an alternative embodiment of the invention, it may be advantageous to select a wavelength that is highly absorbed by the quartz substrate of the photomask such that the all areas of the photomask surface reach the desired process temperature. Considering the thermal properties of the quartz versus the partial absorber layer, it may be expected that thermal transfer between the materials will occur preferentially from quartz to the absorber layer. This is likely because quartz has a relatively low thermal diffusivity and the partial absorber films typically contain a metal component and therefore a higher thermal diffusivity. This embodiment may be required if the temperature differential between the partial absorber and the photomask substrate are critical. For example, it is possible that a differential thermal expansion in the absorber and the substrate could lead to a damage of one or both of the materials. It is also possible that having differing material expansions can weaken the bonding between the partial absorber and substrate and cause separation (delamination). If thermal equilibrium is required between the partial absorber and substrate, use of longer pulse widths may also be preferred to allow sufficient time for thermal transport (conduction) between the materials as the process temperature is achieved.

Considering the above embodiment, operating at a process wavelength where the quartz has a significant absorption at the process wavelength may be preferred because the thermal flow will be preferential to the absorbing films. The main absorption for these substrates generally occurs either below 0.2 $\mu$m wavelength or above 8 $\mu$m wavelength. The shorter wavelengths are not in a particularly desirable wavelength range, because they are usually significantly absorbed by air and because they have higher photon energy and are more likely to produce multiphoton processes.

Selecting a wavelength above 8 $\mu$m, for example near the 9 $\mu$m quartz absorption, is particularly desirable according to certain embodiments of the present invention. This typically produces a high absorption in the quartz substrate without high environmental absorption. This wavelength may also provide an advantage for photomasks that have a partially absorbing film coating (i.e. MoSi). As shown in Figure 2, the example MoSi material has a reduced absorption near 9 um and would therefore have a reduced thermal increase produced directly by the energy source. Generally, the film material temperature reached at constant fluence should be similar to that for quartz because of the high quartz absorption and the higher thermal diffusivity of the partial absorber compared to quartz. This is also expected to be true even if the partially absorbing film has a relatively high absorption coefficient in this wavelength range because of the expected thermal diffusivity advantage. It is possible that selecting other wavelengths in this region would improve the overall thermal uniformity by varying the relative thermal build up in the materials produced by direct absorption of the energy source.

The process just described for use according to certain embodiments of the present invention typically increases the useable lifetime of a photomask by globally modifying the phase delay and/or transmission of the light that travels through the partial absorber film on the photomask surface. There is a limit to the number of conventional "clean processes" that can be performed before a photomask will no longer be useable, since material loss is a consequence of these processes. This is particularly true for photomasks with partially absorbing films, because the loss of material results in a loss of phase and an increase in transmission through the film. By design, the performance of partially absorbing film photomasks is critically dependent on the phase and transmission of the film. Use of the inventive process can produce an increase in the phase delay and/or a decrease in the transmission that effectively recovers the material properties lost to the wet clean. The temperature of the process can be controlled by adjusting the energy provided to the surface, such as, for example controlling pulse duration, pulse amplitude, CW energy, etc.

An additional advantage of a global change in the phase and/or transmission of the photomask could be an improvement in mask-to-mask variability. The number of wet cleans that each mask receives can vary and depends on several of the production parameters. Typically, a photomask will receive wet cleans during the processes required to generate the pattern, as well as wet cleans following repair processes that correct imperfections in the pattern. The final phase and transmission through the partial absorber will depend on the initial amount of partial absorber, fabrication process and the number of wet cleans. This results in mask-to-mask variation in phase and transmission prior to use. Advantageously, mask-to-mask phase and/or transmission variability can be improved by increasing (or decreasing) the phase and/or decreasing (or increasing) the transmission of any particular mask using the processes of the present invention. Accordingly, a different amount of phase and/or transmission adjustment can be applied to different photomasks before use to adjust each mask to the same level of phase and/or transmission. By tightening the variation of these aspects of the photomask, the allowable variation of other mask parameters can be increased. For example, the allowable line-width variation during use can be increased if each photomask has a more precise phase delay. This is of particular advantage in combination with repair processing, since reduced dimensional control, such as, for example, line-width requirements, may provide for a higher photomask yield.

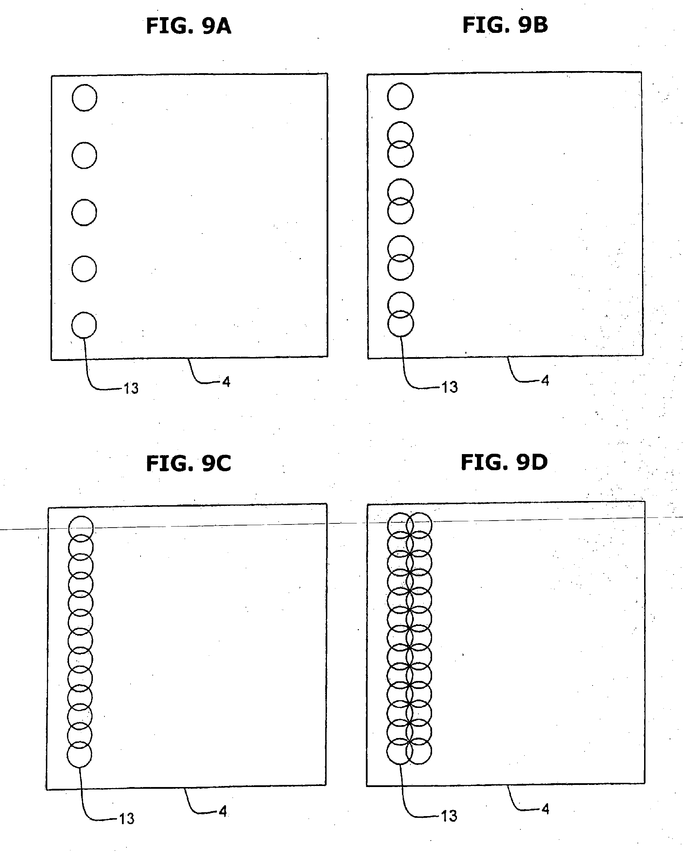

It can be a significant advantage to use a process that produces a fixed or approximately fixed material change independent of the process energy or within a relatively large energy range. This may be expected to be the case for a surface modification process such as oxidation, where the depth of the oxidation may be limited and/or essentially fixed. This may also be expected for a thin film material change process such as annealing since it is possible that the entire depth of the film will be excited to the same temperature and that the annealing process may produce a fixed material change. The average material change could be controlled by processing multiple separated areas on the substrate surface (Figure 9a), if there is a relatively fixed material change produced. In this case, the spacing between the process areas (13) and/or density of process areas relative to unprocessed area could be used to control the relative amount of the material change process.

Use of the process according to certain embodiment of the preset invention may also be used to correct critical dimensions of a partially absorbing photomask. The critical dimensions (CD) of the features on the photomask relate directly to the critical features generated during the wafer print processes. In the case of a partially absorbing film the printed image of the photomask is also determined by phase affects that contribute to the image of the photomask formed on the wafer. Use of the optical proximity correction (OPC) is critical to the functioning of most high end photomasks and is critically dependent on the phase and transmission of the film. By applying a local phase and/or transmission material modification to the partial absorbing material, it is possible that local variations in OPC/CD can be corrected. In addition, if there are broader changes in CD across a photomask, applying different amounts of phase and/or transmission modification can be used to improved the overall uniformity of CD and OPC across a photomask. It is also possible that local CD control could be used to correct for mask print errors, for example, as a repair process for a photomask.

Methods according to certain embodiments of the present invention may be applied to photomask partial absorber modification and do not require removal of the pellicle. In fact, it is often preferable to perform the partial absorber modifications after pellicalization and final inspection verification to ensure that no additional wet cleans are required before use. For example, a laser based phase and/or transmission modification can be performed through the pellicle film material (8) without affecting the pellicle film characteristics (Figure 4). In this case, the absorption of the pellicle film at the process wavelength and the energy density (fluence) at the surface of the pellicle film is typically considered. As with the substrate and substrate film, the material modification process generally does not produce a temperature increase in the pellicle film that is above the damage threshold. Depending on the pellicle film however, there may be significant absorption in the pellicle film near the 9 $\mu$m absorption peaks for the quartz substrate. However, it is still possible to operate in a region of significant pellicle film absorption because the pellicle film is positioned above the substrate surface.

Focusing of the laser beam (12) through the pellicle film, for example with a lens (11), and onto the substrate surface, in addition to wavelength selection, can reduce the relative temperature increase in the pellicle film (Figure 5a). The temperature increase in any substance is proportional to the fluence applied to the surface:

$$\Delta T \sim F \qquad (\text{Equation 1})$$

where $\Delta T$ is the temperature change within the material and F is the absorbed laser fluence.

For a constant intensity or beam pulse energy, the fluence is inversely proportional to the square of the beam spot radius:

$$F \sim E / r2 \qquad (\text{Equation 2})$$

where F is the fluence, E is the energy and r is the radius of the beam on the substrate surface.

The ratio of the beam radius at the pellicle (14) to the beam radius on the mask surface (13) is typically increased by focusing the beam through the pellicle and, therefore, the relative fluence on the pellicle film compared to the photomask substrate surface can be reduced (Figure 5b).

In addition to wavelength considerations, utilizing processes that produce a large temperature increase in the system (e.g., excessively long pulse length or high repetition rate) may be limited by the damage threshold of the pellicle film. The use of pulse-width, relative fluence, process duration, and external material cooling control are example off process parameters that can be used to minimize the temperature increase of the system.

In addition to the example of a MoSi based partially absorbing photomasks, the inventive process may also have a benefit to fully absorbing photomasks and reflective (non-transmitting) photomasks, such as those used in EUV processing. In the case of EUV reflective photomasks, there will typically by multiple material used in fabricating the reflective surface. These may include multiple thin layers of alternating materials, process end stop materials and full or partial absorber materials. The proposed inventive method may be used for material modification of one or more of these materials. In this case, surface morphology and reflectivity may have a more significant role in the photomask performance than phase and transmission. In addition, design of the EUV photomask may be specifically made to support the modification process. For example, a thermally insulating layer may be disposed between the absorber and reflective multilayer to reduce the amount of heat transferred to the multilayer during processing of the partial absorber. As described above for more standard photomasks, it is possible that local or global CD correction of EUV masks is possible with the current invention. Also, errors in the printing of EUV masks could be corrected by modifying the optical properties of one or more of the materials on the EUV photomask. For example, blank substrate surface defects (pits, bumps, particles, etc.) that affect the multilayer reflective coating may be corrected using the current invention.

## Pulse shaping

The pulse width, temporal pulse shape and the spatial distribution of the laser may be used to enhance the material change process or increase the safe operation range for processing according to certain embodiments of the present invention. Shorter pulse widths can be used to minimize the overall thermal input to the system (substrate and environment). Longer pulse widths can be used to maintain the process temperature for an extended period of time enhancing the uniformity of the process and to prevent temperature differentials between different materials. The temporal pulse shape can be used to control the temperature rise within the partial absorber. A long temperature rise can be used to produce an initial effect (e.g., annealing) that would be followed by a secondary effect (e.g., oxidation). The use of multiple pulses can also be used to lower the beam energy that is desirable for complete processing, thereby further decreasing the risk of substrate damage by analogy to utilizing longer pulse-widths. The advantage of multiple pulses being that it is possible that localized cooling of one material may prevent damage while allowing for the process to be performed. For example, the pellicle film could be cooled to prevent multiple pulse thermal build up while the partial absorber is not cooled and the pulse-to-pulse thermal build up is used to reach process temperature in the film.

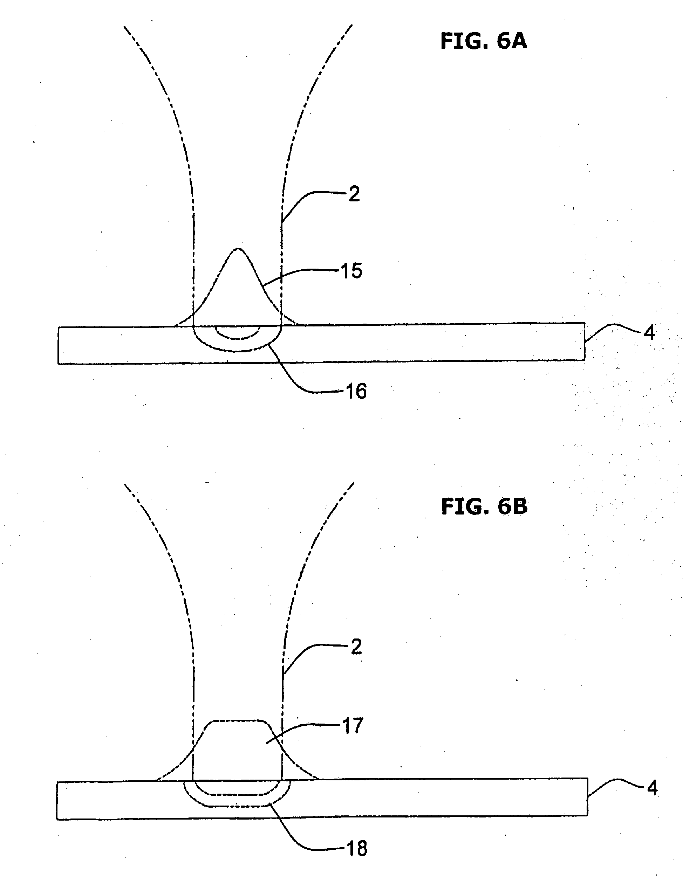

The spatial distribution of the laser beam can be used to increase the process window and process uniformity. For example, (Figure 6a) shows a typical Gaussian spatial distribution (15), that may produce a temperature gradient in the substrate (16) while (Figure 6b) has a flat top or top hat spatial distribution (17) allowing for a more uniform temperature rise within the substrate (18). The spatial distribution can be used to increase the process window. Having a flat-top or top-hat spatial distribution allows for a uniform temperature rise within the beam spot, whereas a Gaussian distribution typically produces a temperature gradient within the beam spot. In order to avoid risk of substrate damage, the maximum energy in the beam is typically limited by the peak of a Gaussian distribution. A Gaussian energy distribution is expected to have a higher risk of exceeding the material damage level compared to a flat top beam if the energy variation is similar to the energy difference between the process and damage energy levels. Also, a Gaussian distribution may produce a non-uniform material change affect, whereas a top-hat energy distribution is expected to produce a more uniform material change within the working area of the beam.

Thermal Management

Because certain embodiments of the present invention involve a thermal based process, it is sometimes desirable to manage the overall temperature of the system to avoid damage to thermally sensitive materials in proximity to the processed material. This is particularly true in the case of photomask material modification processing without pellicle removal. The pellicle films typically have a low thermal damage threshold. Therefore, it is sometimes useful to avoid an overall system temperature build up that may transfer to and/or damage the pellicle material. This includes the pellicle frame and the enclosed environment between the mask surface and the pellicle film.

Managing the system temperature can be accomplished in several ways. The following examples illustrate several representative methods of sample cooling and it is understood that other methods may exist. One way to manage the system temperature is through contact cooling. The photomask, for example, may be placed in contact with a plate (19) that acts as a heat sink to draw the heat generated on the front surface of the mask toward the back of the mask (Figure 7). This reduces the heat transfer to the environment above the mask surface, the pellicle film and the adhesive between the pellicle frame and the mask surface. The cooling can be accomplished in a variety of ways, including flowing water into (21) and out of (20) the heat sink or other cooling fluids or gases over the mask and/or pellicle, thermoelectric cooling or laser induced cooling of a portion or the entirety of the mask and/or pellicle.

Another potential way to control temperature is through forced convection cooling. Filtered and/or cooled gas or liquid flow is typically directed onto portions of the mask (24), onto the pellicle film (23), frame and/or adhesives areas (22) to directly reduce the thermal build up in these materials (Figure 8). This typically does not only reduce the risk of pellicle film damage but also typically reduces the risk of creating contaminating out-gassing from the pellicle frame and pellicle film adhesives. In addition to hardware control of the system thermal buildup, it is possible to reduce thermal build up by allowing for an increased process time. Applying a slower rate of pulses to the system or allowing a delay between a series of pulse application can allow the injected heat to be removed without the total system temperature rising above a critical level.

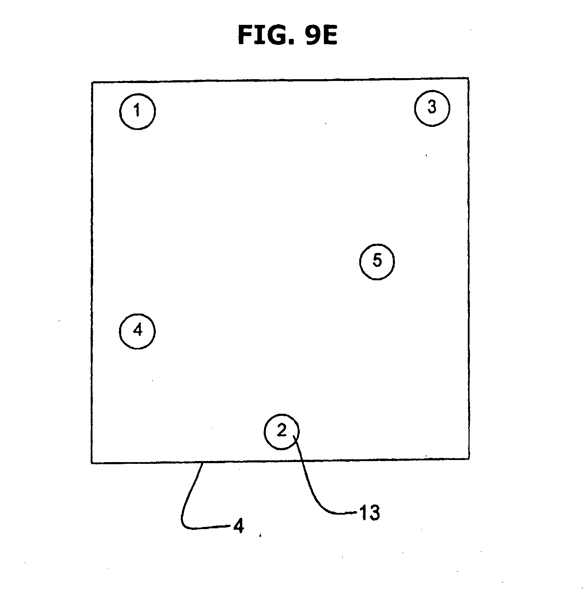

Pulse-to-pulse thermal build up may also advantageously be controlled and may depend on the thermal characteristics of the partial absorber, substrate and/or adjacent materials. In general, pulse to pulse thermal build up can be controlled by reducing the number of laser pulses hitting the surface per unit time. This temperature build up can also be controlled by increasing the distance between adjacent laser pulses. It may be particularly desirable to have a large lateral displacement between adjacent pulses, where the material is particularly sensitive to pulse-to-pulse thermal build (e.g., pellicle film materials). In this case, the process typically involves positioning the laser beam at nearly the same locations multiple times to obtain the desired material modification of the target surface. For example, a first series of laser pulses are exposed to the surface with a relatively large lateral separation (Figure 9a). A second pass over the same area places an additional series of laser pulses that are slightly shifted relative to the first set of spots (Figure 9b). This process continues until the entire area has been exposed to the laser pulses (Figure 9c). Overlap in a second direction can be used, according to certain embodiments of the present invention, to completely expose a substrate surface (Figure 9d). According to certain embodiments of the present invention, this overall process is repeated and/or the overlap between passes is increased, particularly if it is desirable for the material modification process to include multiple pulses for process completion. Changing the position of the beam relative to the surface as illustrated can be accomplished by moving the beam and/or moving the substrate. In addition, applying pulses in a more systematically distributed manner across the mask may reduce further the likelihood of thermal buildup on the mask (Figure 9e).

Technology Combination

The current invention could be used in conjunction with surface preparation or environmental control techniques to extend reticle lifetim-e. Some of these techniques may require processing before pellicle mounting while others can be performed post-pellicalization. For example, a surface preparation method in conjunction with the present invention could provide for an increased material modification result. This process affect could then result from, for example, incorporating an alternative material into the partial absorber or enhancing the thermal buildup in the partial absorber.

In addition, adding a new material to the top of the partial absorber (or substrate) could be used to affect the overall performance of the partial absorber material. Although not necessarily a direct modification of the partial absorber, there may be advantages to using this embodiment of the invention. In the case of adding a material to the top of the partial absorber, the process may include a removal of residual surface preparation material. In addition, the added material may be removed by subsequent clean processes so that the process can be repeated.

Environmental control techniques can also be used in combination with the inventive method. Techniques that control the environment both inside and outside the pellicle and pre pellicle could be used in combination with the inventive material modification process.

One embodiment would include exchanging the environment under the pellicle with a gas that will react with the partial absorber material to change the material properties. This could be performed without pellicle removal by gas exchange through a filtered vent on the pellicle frame. It may be additionally advantageous to maintain an inert environment inside or outside of the pellicle in conjunction with the present invention to enhance bulk absorber properties relative to surface material change processes. These combination processes could increase the relative phase delay or transmission modification and therefore extend further the lifetime of the photomask.

Metrology

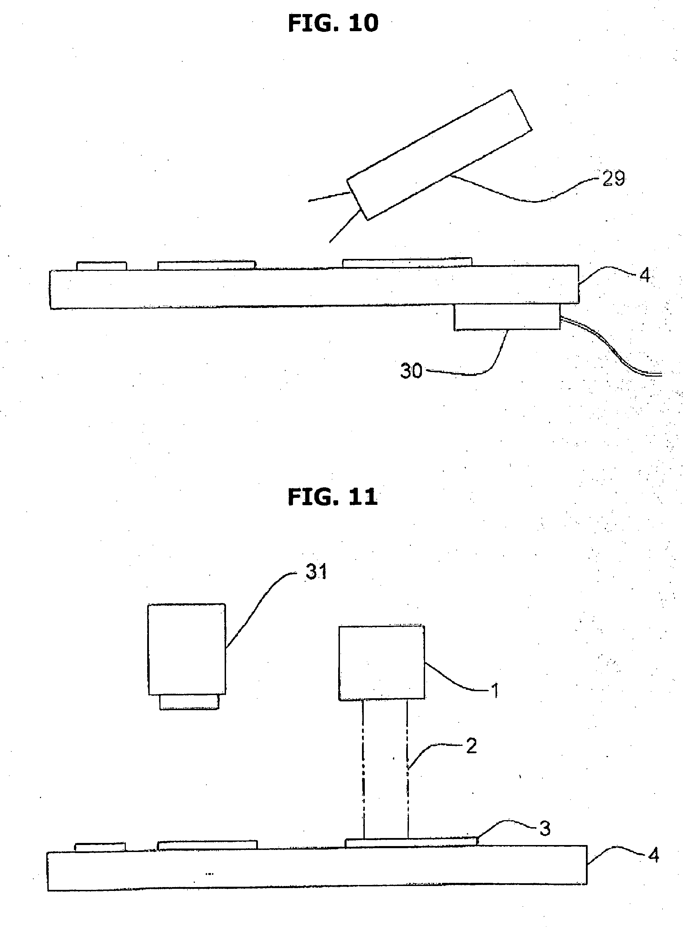

Methods according to certain embodiments of the present invention may also be used in combination with metrology to monitor the critical process parameters and/or to evaluate the progression or completion of the material modification process. Measurement of the locally generated temperature of the substrate materials can, for example, be used in combination with material change. Temperature measurement can be evaluated prior to application of the process in order to verify risk of temperature related damage. In addition, these temperatures may be monitored during the material modification process to verify process control and/or reduce the risk of material damage. For example, according to certain embodiments of the present invention, the temperature of the substrate and/or absorber film is monitored during the process and has the ability to feed back control of the energy applied to maintain the desired process or turn off the process if too large a temperature build up is detected. Multiple devices and methods of temperature monitoring exist and include contact (30) (e.g., thermal-couples) and non-contact (29) (e.g., infrared cameras) devices and methods (Figure 10).

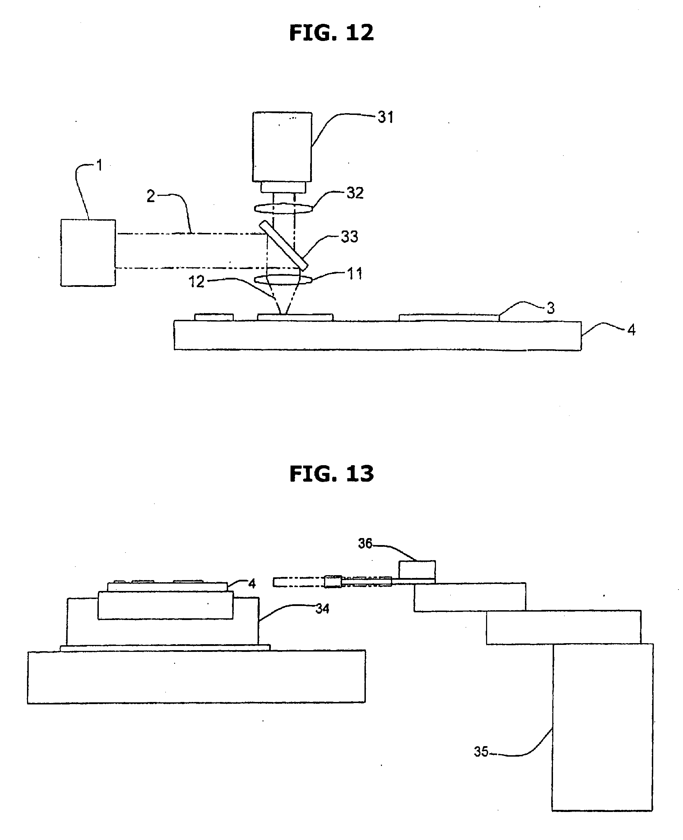

Metrology devices (31) and methods can also be used, according to certain embodiments of the present invention, to analyze or monitor the material properties of the substrate and/or materials on or adjacent to the substrate prior to, during and/or after the removal process (Figure 11). For example, measurement of the material properties of a partial absorber film on the substrate can be used to calculate the phase delay and/or transmission of the material before processing. This could be used to determine the process temperature for material modification in order to induce an appropriate phase delay in the absorber film. This metrology could also be used to monitor the phase and/or transmission during processing and feedback information to the process or stop the processes if it is outside a process limit. Material property analysis of the substrate could be used to determine the correct energy to induce a desired partial absorber material or morphology change. In addition, the material properties of the pellicle film could be monitored to determine if an adverse affect is occurring to the pellicle material. This information could be used before processing to limit process temperature, or during processing to stop the process if damage is observed. For example, one or more ellipsometers could be used to measure the material response of the pellicle film, absorber film and substrate surface. This data can then be used to calculate the desired material properties including film thickness, transmission and phase. It is possible that the measurement devices could share a common optical path with the process energy source (Figure 12). For example, the energy source (1) may be coupled into the measurement device (31) path using a beam splitting device (33). Additional optical elements (32) may also be required to properly collect the metrology data, as illustrated in Figure 12.

In the case of a photomask, for example, multiple metrologies may be incorporated into the material modification process according to certain embodiments of the present invention. Identifying the phase delay and transmission over the entire photomask reticle, for example, may define the processing temperature requirement. Identifying the local or global material variations on a photomask may be used to determine the lateral dimensions for process application and multiple energy levels to use for processing different locations/sections across the photomask.

According to certain embodiments of the present invention, transmitted light intensity is measured and the results are compared to other sections of the absorbing film. Discrepancies between programmed features and detected features are then used to determine local variations in material properties required to improve uniformity. In addition, Aerial Imaging Measurement is used according to certain embodiments of the present invention to evaluate the print characteristics of the photomask. These measurements can be used in-situ to detect damage to the absorber layer resulting from the material modification process.

Metrology is also used according to certain embodiments of the present invention to monitor the characteristics of materials adjacent to the surface being cleaned. For example, the temperature of a pellicle film above a photomask may be monitored to reduce the risk of pellicle film damage. The transmission characteristics of the pellicle film can also be used to qualify the affects of the process during or after the processing.

As will be appreciated by one of skill in the art upon practicing one or more embodiments of the present invention, the metrology examples discussed above are not intended to be all inclusive of the present invention. Rather, these examples merely illustrate the use of metrology within some methods according to the present invention.

Apparatus

Certain methods according to embodiments of the present invention are incorporated into apparatuses used to perform the material modification process. An example of such an apparatus additionally include robotic handling (35) of the substrate material and/or one or more axes of motion (34) to position the substrate sample relative to an external energy source (Figure 13). Robotic handling may include substrate gripping end-effector (36) for transferring the substrate between positions. The apparatus may, for example, contain one or more of the metrologies as described above and/or may include ways of controlling the temperature of the substrate and/or adjacent materials during the material modification process. In addition, the apparatus may include metrology used to register the substrate to the staging system and therefore to the laser beam. This metrology may also include computer controlled vision recognition systems. Further, the apparatus may also utilize computer control of the laser, motion and/or metrology and may provide for software based recipe control of the material modification process. Laser energy source control may, for example, include controlling when laser pulses are applied as well as the amount of energy applied during the process.

Reticle Fabrication Process

A method and/or apparatus according to certain embodiments of the present invention can be used as part of a novel reticle fabrication process that includes the modification of the phase and/or transmission of a partial absorber on a photomask surface. According to certain embodiments of the invention, the material modification process can be used to adjust an overall property of the partial absorbing film prior to, during or following photomask fabrication processes, including photomask repair processing. The photomask may or may not be pellicalized prior to processing. Certain embodiments may also be applied to the photomask following clean processing and may be applied to the same photomask as part of the standard clean processing. According to certain embodiment of the present invention, material modification may be used to correct for phase loss and/or transmission increase resulting for the wet clean processing. As a result, the process may be used to extend the lifetime of a photomask beyond what is currently achievable by allowing additional wet clean processing and/or re-pellicalization(s) prior to discard. Duplicate sets of photomasks are typically required because the photomasks must be discarded. Therefore, the inventive method also provides for cost reduction by extending the useful life of a photomask and reducing the requirement for duplicate masks in order to complete a production run.

A novel photomask reticle fabrication method according to certain embodiments of the present invention incorporates an apparatus utilizing one or more of the methods discussed above to modify the partial absorber properties of the photomask. A typical reticle fabrication process according to an embodiment of the present invention includes multiple wet clean processes applied to a photomask during fabrication. The number of wet clean processes varies from mask-to-mask so that there is a final film thickness variation between masks. According to an embodiment of the current invention, utilizes one or more of the material modification methods described above to globally change the phase and/or transmission of each photomask different amounts so that the final phase and/or transmission variation between masks is reduced. According to another embodiment of the present invention, a reticle fabrication process incorporating the use of one or more of the inventive methods can be used to recover phase loss and/or transmission increase (globally or locally) to extend the useful life of the photomask.

In addition to mask-to-mask optical performance variability, each wet clean processes adds variability to the material properties across a single photomask surface. It is possible that the variability of the phase and/or transmission on a single photomask will be out of acceptable limits after wet clean processing. This is particularly true as the number of wet clean processes is increased. According to an embodiment of the current invention, a novel photomask reticle fabrication process is provided that incorporates an apparatus utilizing one or more of the material modification methods described above to improve the uniformity of optical characteristics of the photomask. This may include producing non-uniform changes across the entire photomask or one or more local changes in the material properties, including phase and/or transmission. According to certain embodiments of the current invention, non-uniform material changes are used to extend the useful life of the photomask by correcting non-uniformity in the photomask optical properties.

According to certain embodiments of the present invention, a novel reticle wafer fabrication process reduced the use of additional masks or mask sets for product manufacture by extending the photomask lifetime.

The many features and advantages of the invention are apparent from the detailed specification, and, thus, it is intended by the appended claims to cover all such features and advantages of the invention which fall within the scope of the invention. Further, since numerous modifications and variations will readily occur to those skilled in the art, it is not desired to limit the invention to the exact construction and operation illustrated and described, and, accordingly, the scope of the invention is defined by the appended claims.

**Claims**

1. A method for improving the optical characteristics of a photomask, comprising:

    directing an electromagnetic radiation (2) towards a photomask substrate (4) having a partially-absorbing thin film (3) disposed thereon, the electromagnetic radiation (2) having a wavelength that substantially coincides with a high absorption coefficient of the photomask substrate (4);

generating a temperature increase in the photomask substrate (4); and

modifying at least one of a phase and a transmission of the thin film (3), **characterized in that** the wavelength is above 8 micrometers.

2. The method of claim 1, wherein said modifying includes at least one of increasing the phase and decreasing the transmission.

3. The method of claim 1, wherein said modifying includes at least one of decreasing the phase and increasing the transmission.

4. The method of claim 1, wherein the photomask is at least partially enclosed within a pellicle and further comprising directing the electromagnetic radiation through a pellicle film positioned above the photomask substrate.

5. The method of claim 4, wherein the electromagnetic radiation is further directed towards the thin film, and the wavelength of the electromagnetic radiation substantially coincides with a high absorption coefficient of the thin film.

6. The method of claim 1, for increasing the usable lifetime of the photomask, wherein the thin film (3) has a phase delay loss; and
the modifying of the phase comprises
recovering at least a potion of the phase delay loss.

7. The method of claim 6, further comprising directing the electromagnetic radiation through a material positioned above the photomask substrate.

8. The method of claim 6, wherein the photomask substrate is at least partially enclosed within a pellicle and the material is a pellicle film.

9. The method of claim 6, wherein the substrate is quartz and the electromagnetic radiation wavelength is about 9 micrometers.

10. The method of claim 6, wherein the recovering is a result of oxidation or annealing.

11. The method of claim 6, wherein the phase delay recovering occurs concurrent with surface cleaning.

12. The method of claim 6, further comprising recovering differing amounts of the phase delay loss within the partial absorber layer to improve overall uniformity of critical dimensions and optical proximity correction across the photomask.

13. The method of claim 6, further comprising maintaining a temperature of the photomask substrate below a threshold temperature to prevent damage thereto.

14. The method of claim 6, wherein the substrate includes at least two materials, wherein the wavelength substantially coincides with a high absorption coefficient of at least two of the materials.

**Patentansprüche**

1. Verfahren zur Verbesserung der optischen Eigenschaften einer Fotomaske, mit den Schritten:

Richten einer elektromagnetischen Strahlung (2) auf ein Fotomaskensubstrat (4), auf dem eine teilweise absorbierende Dünnschicht (3) angeordnet ist, wobei die elektromagnetische Strahlung (2) eine Wellenlänge aufweist, die im Wesentlichen mit einem hohen Absorbtionskoeffizienten des Fotomaskensubstrats (4) übereinstimmt;
Erzeugen eines Temperaturanstiegs im Fotomaskensubstrat (4) und
Verändern von zumindest einer Phase oder einer Übertragung der Dünnschicht (3), **dadurch gekennzeichnet, dass** die Wellenlänge länger als 8 $\mu$m ist.

2. Verfahren nach Anspruch 1, wobei das Verändern zumindest eine Erhöhung der Phase oder eine Verringerung der Übertragung umfasst.

3. Verfahren nach Anspruch 1, wobei das Verändern zumindest eine Verringerung der Phase oder eine Erhöhung der Übertragung umfasst.

4. Verfahren nach Anspruch 1, wobei die Fotomaske zumindest teilweise in ein Pellikel eingeschlossen ist, und das ferner das Leiten der elektromagnetischen Strahlung durch eine Pellikelschicht umfasst, die oberhalb des Fotomaskensubstrats platziert ist.

5. Verfahren nach Anspruch 1, wobei ferner die elektromagnetische Strahlung zu der Dünnschicht geleitet wird, und die Wellenlänge der elektromagnetischen Strahlung im Wesentlichen mit einem hohen Absorptionskoeffizienten der Dünnschicht übereinstimmt.

6. Verfahren nach Anspruch 1 zur Erhöhung der nutzbaren Lebensdauer der Fotomaske, wobei die Dünnschicht (3) einen Phasenverzögerungsverlust aufweist und das Verändern der Phase die Rückgewinnung zumindest eines Teils des Phasenverzögerungsverlustes umfasst.

**7.** Verfahren nach Anspruch 6, das ferner das Leiten der elektromagnetischen Strahlung durch ein oberhalb des Fotomaskensubstrats platziertes Material umfasst.

**8.** Verfahren nach Anspruch 6, wobei das Fotomaskensubstrat zumindest teilweise in ein Pellikel eingeschlossen ist und das Material eine Pellikelschicht ist.

**9.** Verfahren nach Anspruch 6, wobei das Substrat aus Quarz ist und die Wellenlänge der elektromagnetischen Strahlung etwa 9 $\mu$m beträgt.

**10.** Verfahren nach Anspruch 6, wobei die Rückgewinnung das Ergebnis eines Oxidationsvorgangs oder eines Ausheilvorgangs ist.

**11.** Verfahren nach Anspruch 6, wobei die Phasenverzögerungsrückgewinnung gleichzeitig mit der Oberflächenreinigung auftritt.

**12.** Verfahren nach Anspruch 6, das ferner die Rückgewinnung verschiedener Mengen des Phasenverzögerungsverlustes innerhalb der Teilabsorptionsschicht zum Verbessern der allgemeinen Gleichmäßigkeit der kritischen Abmessungen und die optische Nahbereichskorrektur über der Fotomaske umfasst.

**13.** Verfahren nach Anspruch 6, das ferner das Halten der Temperatur des Fotomaskensubstrats unterhalb einer Schwellentemperatur umfasst, um Schäden daran zu verhindern.

**14.** Verfahren nach Anspruch 6, wobei das Substrat mindestens zwei Materialien umfasst und die Wellenlänge im Wesentlichen mit dem hohen Absorptionskoeffizienten von zumindest zwei der Materialien übereinstimmt.

**Revendications**

**1.** Procédé d'amélioration des caractéristiques optiques d'un masque photographique, comprenant le fait :

de diriger un rayonnement électromagnétique (2) vers un substrat de masque photographique (4) ayant un film mince partiellement absorbant (3) disposé sur celui-ci, le rayonnement électromagnétique (2) ayant une longueur d'onde qui coïncide substantiellement avec un coefficient d'absorption élevé du substrat de masque photographique (4) ;

de générer une augmentation de température dans le substrat de masque photographique (4) ; et
de modifier au moins l'une d'une phase et d'une transmission du film mince (3),
**caractérisé en ce que**
la longueur d'onde est supérieure à 8 micromètres.

**2.** Procédé de la revendication 1, dans lequel ladite modification comporte au moins l'une d'une augmentation de la phase et d'une diminution de la transmission.

**3.** Procédé de la revendication 1, dans lequel ladite modification comporte au moins l'une d'une diminution de la phase et d'une augmentation de la transmission.

**4.** Procédé de la revendication 1, dans lequel le masque photographique est au moins partiellement enfermé dans une pellicule et comprenant en outre le fait de diriger le rayonnement électromagnétique à travers un film pelliculaire positionné au-dessus du substrat de masque photographique.

**5.** Procédé de la revendication 4, dans lequel le rayonnement électromagnétique est dirigé en outre vers le film mince, et la longueur d'onde du rayonnement électromagnétique coïncide substantiellement avec un coefficient d'absorption élevé du film mince.

**6.** Procédé de la revendication 1, pour augmenter la durée de vie utile du masque photographique, dans lequel le film mince (3) a une perte de retard de phase ; et
la modification de la phase comprend
la récupération d'au moins une partie de la perte de retard de phase.

**7.** Procédé de la revendication 6, comprenant en outre le fait de diriger le rayonnement électromagnétique à travers un matériau positionné au-dessus du substrat de masque photographique.

**8.** Procédé de la revendication 6, dans lequel le substrat de masque photographique est au moins partiellement enfermé dans une pellicule et le matériau est un film pelliculaire.

**9.** Procédé de la revendication 6, dans lequel le substrat est du quartz et la longueur d'onde de rayonnement électromagnétique est d'environ 9 micromètres.

**10.** Procédé de la revendication 6, dans lequel la récupération est le résultat de l'oxydation ou du recuit.

**EP 2 176 708 B1**

**11.** Procédé de la revendication 6, dans lequel la récupération de retard de phase se produit en même temps qu'un nettoyage de surface.

**12.** Procédé de la revendication 6, comprenant en outre le fait de récupérer des différentes quantités de la perte de retard de phase dans la couche partiellement absorbante pour améliorer l'uniformité globale des dimensions critiques et la correction de proximité optique à travers le masque photographique.

**13.** Procédé de la revendication 6, comprenant en outre le fait de maintenir une température du substrat de masque photographique en dessous d'une température seuil pour empêcher son endommagement.

**14.** Procédé de la revendication 6, dans lequel le substrat comporte au moins deux matériaux, dans lequel la longueur d'onde coïncide substantiellement avec un coefficient d'absorption élevé d'au moins deux des matériaux.

**FIG. 1A**

**FIG. 1B**

## FIG. 2

### MOSI PHOTOMASK FILM ABSORBTION SPECTRA

## FIG. 3

### FUSED SILICA PHOTOMASK BLANK ABSORBTION SPECTRA

**FIG. 4**

**FIG. 5A**

**FIG. 5B**

**FIG. 5C**

FIG. 6A

FIG. 6B

## FIG. 7

## FIG. 8

**FIG. 9A**

**FIG. 9B**

**FIG. 9C**

**FIG. 9D**

# FIG. 9E

# FIG. 10

# FIG. 11

# FIG. 12

# FIG. 13

## REFERENCES CITED IN THE DESCRIPTION

**Patent documents cited in the description**

- US 61040291 A
- US 95498907 P
- WO 0227404 A2
- US 20060007433 A1
- US 5728494 A
- US 20060254611 A1
- EP 1353224 A1
- US 20070128552 A1
- US 6407385 B1
- EP 1777587 A1